# DEMANDE DE BREVET EUROPEEN

(11) **EP 1 054 075 A1**
(43) Date de publication de la demande: **22.11.2000**
(21) Numéro de dépôt: 00401232.4
(22) Date de dépôt: 05.05.2000
(51) Int. Cl.: C23C 14/08, C23C 16/40, C23C 30/00, C04B 35/46

(54) **Pièce mécanique de friction recouverte d'oxydes triboctifs stabilisés pas des oligoéléments**

(30) Priorité: 18.05.1999 FR 9906298
(71) Demandeur: Renault, 92100 Boulogne Billancourt (FR)
(72) Inventeur: Criqui, Bernard, 92150 Suresnes (FR); Desplanches, Gérard, 91120 Palaiseau (FR)

(57) **Abrégé**

La présente invention concerne des pièces mécaniques de friction pour moteurs à combustion interne portant un revêtement anti-usure à base d'oxydes métalliques présentant des défauts plans d'oxygène et stabilisés par la présence d'oligoéléments choisis parmi Al, Ti, Zr, Co, Cr, Fe, Ni, Mn, Nb et K.

## Description

La présente invention concerne des pièces mécaniques de friction pour moteurs à combustion interne lubrifiés par un fluide, portant un revêtement anti-usure à base d'oxydes métalliques particuliers stabilisés par la présence d'oligoéléments.

La lubrification des moteurs de véhicules automobiles par des lubrifiants traditionnels à base d'huiles minérales contenant une fraction importante d'additifs (anti-usure, extrême-pression, indice de viscosité, anti-corrosion etc.) pose d'importants problèmes liés d'une part à la toxicité et aux nuisances écologiques que présentent ces huiles moteur, et d'autre part à la nécessité, pour l'utilisateur, de renouveler à des intervalles réguliers ces huiles usées par la dégradation et l'épuisement des additifs.

Une approche intéressante pour résoudre ces problèmes a consisté à transférer une partie des fonctions assumées classiquement par l'huile moteur sur des revêtements des pièces mécaniques soumises à des frottements. Les matériaux formant ces revêtements capables de remplir ces fonctions de lubrification seront appelés par la suite matériaux "tribo-actifs".

Un groupe de tels matériaux tribo-actifs est constitué d'oxydes métalliques particuliers formant ce que l'on appelle, d'après leur découvreur Arne Magnéli, les phases de Magnéli. Il s'agit d'oxydes de titane, de vanadium, de molybdène et de tungstène présentant un défaut stoechiométrique d'atomes d'oxygène.

Dans le réseau cristallin, ces lacunes d'atomes d'oxygène sont organisées en plans, appelés par la suite défauts plans d'atomes d'oxygène. Ces défauts plans d'atomes d'oxygène constituent des plans de glissement, ou de dislocation du réseau cristallin qui confèrent à ces oxydes leur propriétés lubrifiantes (contraintes de cisaillement relativement faibles, c'est-à-dire inférieures à 100 MPa).

Ces oxydes formant des phases de Magnéli font partie de ce que l'on appelle dans la littérature anglo-saxone les *Lubricious Oxides* (oxydes lubrifiants) et peuvent être décrits par les formules chimiques suivantes :

TiₙO₂ₙ₋₁, VₙO₂ₙ₋₁, MoₙO₃ₙ₋₁ et WₙO₃ₙ₋₁

dans lesquelles 3 ≤ n ≤ 10.

Un autre oxyde tribo-actif présentant des défauts stoechiométriques d'oxygène organisés en plans similaires est l'oxyde de chrome sous-stoechiométrique de formule

CrO_{2-y},

avec 0,01 ≤ y ≤ 0,5 qui doit être rangé dans le groupe des oxydes tribo-actifs décrits ci-dessus bien qu'il n'appartienne pas, pour des raisons purement historiques, aux phases de Magnéli.

Les demandes de brevet allemand DE 195 48 718 et DE 196 51 094 décrivent des pièces mécaniques soumises à des frottements, portant des revêtements anti-usure à base des oxydes de Ti, V, Mo, W et Cr présentant des défauts plans d'oxygène décrits ci-dessus. Ces oxydes tribo-actifs sont soit appliqués directement à la surface de la pièce soit se forment in *situ* dans les conditions de fonctionnement du moteur (pression, température, présence d'oxygène) à partir d'un matériau précurseur choisi parmi les carbure, nitrure et nitrocarbures des métaux correspondants.

Comme indiqué ci-dessus, les propriétés de lubrification de ces oxydes sous-stoechiométriques reposent sur la présence de défauts plans d'atomes d'oxygène. Or, ces défauts sont sensibles à l'oxydation car les lacunes d'atomes d'oxygène peuvent être comblées par l'oxygène de l'air ou l'oxygène dissous dans le fluide lubrifiant, en particulier dans les microcontacts où des températures de pointe de 1500 °C ont été mises en évidence.

La présente invention est basée sur la découverte surprenante qu'il était possible d'améliorer la stabilité à l'oxydation à haute température ou à long terme de ces oxydes tribo-actifs en y incorporant de faibles quantités d'oligoélements sous forme métallique ou sous forme d'oxydes.

La demanderesse a constaté par ailleurs que cette incorporation d'oligoéléments favorise également la formation *in situ* des oxydes tribo-actifs par oxydation des matériaux précurseurs sous l'effet de la chaleur et des contraintes de cisaillement dans les microcontacts.

L'objet de la présente invention est par conséquent une pièce mécanique de friction pour moteurs à combustion interne revêtue, sur une partie ou sur la totalité de sa surface, d'une couche comprenant au moins un oxyde métallique présentant un défaut stoechiométrique d'oxygène ou un précurseur d'un tel oxyde, et contenant une quantité suffisante pour stabiliser ledit oxyde métallique vis-à-vis de l'oxydation, d'au moins un oligoélément choisi parmi Al, Ti, Zr, Co, Cr, Fe, Ni, Mn, Nb et K, différent du métal formant l'oxyde métallique.

L'invention a également pour objet des procédés de fabrication d'une pièce mécanique de friction décrite ci-dessus par dépôt chimique en phase vapeur, par dépôt physique en phase vapeur, par projection thermique, par traitement thermochimique ou par placage chimique ou électrochimique.

Un autre objet de l'invention est l'utilisation d'oligoéléments choisis parmi Al, Ti, Zr, Co, Cr, Fe, Ni, Mn, Nb et K pour stabiliser des revêtements anti-usure à base d'oxydes métalliques présentant un défaut stoechiométrique d'oxygène.

Les revêtements anti-usure de la présente invention peuvent soit être formés de couches homogènes, c'est-à-dire de couches constituées d'une seule phase d'oxyde triboactif ou d'un précurseur de celui-ci, soit être des couches composites constituées d'une matrice renfermant des particules dudit oxyde triboactif ou d'un précurseur de celui-ci.

Lorsque le revêtement est une couche composite, la matrice peut être une matrice métallique constituée de fer, de fonte, de nickel, de nickel-phosphore, de chrome ou de cobalt ou d'un alliage de ceux-ci, ou bien une matrice céramique constituée d'Al₂O₃, de ZrO₂, de Cr₂O₃ ou de TiO₂, ou d'un mélange de ceux-ci.

Dans le cas d'un revêtement composite, la proportion en particules de ladite couche composite est comprise entre 10 et 80 % en poids.

La taille moyenne de ces particules d'oxyde triboactif ou de précurseur d'oxyde triboactif est généralement comprise entre 0,5 µm et 20 µm. Lorsque les revêtements sont déposés par projection thermique, la taille des particules doit être au moins égale à 10 µm.

Les oxydes métalliques présentant un défaut stoechiométrique d'oxygène que l'on peut utiliser pour les revêtements tribo-actifs selon la présente invention englobent les oxydes à défauts plans d'atomes d'oxygène formant des phases dites de Magnéli décrites ci-dessus, de formule

TiₙO_{2n,1},

VₙO₂ₙ₋₁,

MoₙO₃ₙ₋₁,

MoₙO₃ₙ₋₂,

WₙO₃ₙ₋₁,

et

WₙO₃ₙ₋₂

dans lesquelles 3 ≤ n ≤ 10, c'est-à-dire des oxydes ayant une structure cristalline dans laquelle en moyenne un motif sur trois à un motif sur dix présente une ou deux lacune(s) d'oxygène, et l'oxyde de chrome de formule

CrO_{2-y},

où 0,01 ≤ y ≤ 0,5.

Comme indiqué ci-dessus, ces oxydes peuvent soit être déposés tels quels sur la pièce mécanique de base soit ils peuvent se former *in situ* dans les conditions de fonctionnement du moteur à partir d'un précurseur non oxydé. Ce phénomène appelé tribo-oxydation se produit dans des conditions particulières de température et de contrainte de cisaillement et en présence d'oxygène. Cette formation *in situ* présente un certain avantage par rapport au dépôt direct de l'oxyde tribo-actif car elle permet la régénération d'une couche d'oxyde triboactif mince (épaisseur < 1 µm) au fur et à mesure de son élimination.

Les précurseurs permettant la formation des oxydes tribo-actifs englobent les carbures, les nitrures et les borures des métaux correspondants, ainsi que des mélanges (solutions solides) de ceux-ci. On utilisera de préférence les carbures et les nitrures.

Pour avoir une stabilité satisfaisante à température élevée ou à long terme, les oxydes triboactifs de la présente invention ou les précurseurs donnant naissance à ces oxydes doivent contenir une faible quantité d'autres atomes métalliques désignés, dans le contexte de la présente demande, par le terme *d'oligoéléments.*

Ces oligoéléments englobent les atomes Al, Ti, Zr, Co, Cr, Fe, Ni, Mn, Nb et K.

Il est bien entendu que, lorsque l'oxyde tribo-actif est constitué pour partie ou en totalité de dioxyde de titane ou de dioxyde de chrome, l'élément titane ou l'élément de chrome doit être exclu de cette liste d'oligoéléments.

Ce ou ces oligoéléments peuvent être introduit(s) dans l'oxyde tribo-actif ou dans le précurseur non oxydé correspondant, soit sous forme métallique, soit sous forme d'oxyde.

Lorsqu'on les incorpore sous forme métallique, la quantité d'oligoéléments est comprise généralement entre 30 et 3000 ppm en poids, de préférence entre 300 et 1000 ppm en poids.

Dans le cas où les oligoéléments sont incorporés non pas sous forme métallique mais sous forme d'oxyde, p. ex. sous forme Al₂O₃, TiO₂, ZrO₂, CO₃O₄, Cr₂O₃, Fe₂O₃, NiO, Nb₂O₅ ou K₂O, la teneur en oxyde, exprimée en % d'atomes de métal et d'atomes d'oxygène, est comprise entre 3 et 30 %, et de préférence entre 10 et 25 %.

On peut également envisager d'introduire les oligoéléments dans le revêtement à base d'un oxyde triboactif d'une première pièce mécanique en déposant à la surface d'une deuxième pièce mécanique qui sera en frottement avec la première pièce, un oxyde d'un des oligoéléments de la présente invention. Dans les conditions de fonctionnement du moteur, c'est-à-dire à température élevée et sous de fortes contraintes de cisaillement, l'oligoélément de la deuxième pièce diffusera dans la couche d'oxyde triboactif de la première pièce et la stabilisera vis-à-vis de l'oxydation.

L'invention a donc également pour objet un dispositif constitué d'un premier triboélément revêtu, sur une partie ou sur la totalité de sa surface, d'une couche d'au moins un oxyde métallique présentant un défaut stoechiométrique d'oxygène, et d'un deuxième élément revêtu d'un oxyde de Al, Ti, Zr, Co, Cr, Fe, Ni, Mn, Nb et K.

L'épaisseur de la couche comprenant au moins un oxyde triboactif ou un précurseur d'un tel matériau dépend de la nature du revêtement et du procédé de dépôt choisi et elle sera ajustée en fonction des contraintes tribologiques auxquelles sera soumise la pièce. D'une manière générale, l'épaisseur de cette couche comprenant au moins un oxyde triboactif présentant un défaut stoechiométrique d'oxygène ou un précurseur d'un tel oxyde, stabilisé par la présence d'oligoéléments est comprise entre 1 µm et 1000 µm, et de préférence entre 10 µm et 200 µm.

Le dépôt des revêtements anti-usure à base d'oxydes triboactifs, ou de précurseurs de tels oxydes, stabilisés par des oligoéléments peut se faire selon des procédés de traitement de surfaces métalliques connus tels que la projection thermique, le dépôt chimique en phase vapeur (CVD) et le dépôt physique en phase vapeur (PVD).

Ces types de traitement de surface conviennent en particulier pour des arbres à cames, des poussoirs, des pistons, des segments, des chemises, des guides de soupapes, des paliers pour vilebrequins, des bielles, des cylindres de carter, des cylindres à fûts intégrés, des engrenages de pompe à huile de moteurs.

Les pièces de base peuvent également être soumises à un traitement thermochimique consistant à faire diffuser, à température élevée, un agent de traitement thermochimique contenant une quantité appropriée d'oligoéléments stabilisants. On peut citer à titre d'exemple :
- la *vanadation* des pièces mécaniques par diffusion, à une température comprise entre 600 °C et 1000 °C, d'un agent de vanadation contenant un ou plusieurs oligoéléments en une quantité telle que la concentration en oligoéléments de la couche de surface formée soit comprise entre 30 et 3000 ppm. Les couches de surface formées par ce procédé s'étendent généralement jusqu'à une profondeur comprise entre 5 µm et 30 µm.
   La vanadation est un procédé décrit dans plusieurs brevets (US 3 887 433, US 4 250 208 et US 4 686 117). Ce procédé convient tout particulièrement pour des arbres à cames, des axes de piston, des anneaux/segments et des poussoirs.
- la *boruration* des pièces mécaniques par diffusion, à une température comprise entre 800 °C et 1000 °C, d'un agent de boruration contenant un ou plusieurs oligoéléments en une quantité telle que la concentration en ces oligoéléments de la couche de surface formée soit comprise entre 30 et 3000 ppm. Les couches de surface formées par ce procédé s'étendent généralement jusqu'à une profondeur comprise entre 5 µm et 500 µm.

Ce traitement s'appliquera surtout à des pièces mécaniques telles que des guides de soupapes, des arbres à cames, des axes de piston, des anneaux/segments et des poussoirs.

Comme procédés de dépôt de revêtements composites à matrice métallique, on peut citer le placage par voie électrochimique ou chimique avec une dispersion de particules d'oxyde présentant un défaut stoechiométrique d'oxygène ou d'un précurseur de celui-ci, stabilisé par la présence d'une quantité suffisante d'au moins un oligoélément choisi parmi Al, Ti, Zr, Co, Cr, Fe, Ni, Mn, Nb et K, différent du métal formant l'oxyde métallique.

Un autre procédé permettant l'obtention de revêtements composites à matrice métallique ou céramique consiste à soumettre la pièce mécanique de base à une projection thermique avec une dispersion de particules d'au moins un oxyde métallique présentant un défaut stoechiométrique d'oxygène et stabilisé par la présence d'une quantité suffisante d'au moins un oligoélément choisi parmi Al, Ti, Zr, Co, Cr, Fe, Ni, Mn, Nb et K, différent du métal formant l'oxyde métallique, de manière à former sur une partie ou sur la totalité de la surface de la pièce de base un revêtement composite (matrice contenant des particules desdits oxydes).

Ces procédés de traitement de surface conviennent en particulier pour des chemises, des tiges de soupapes, des poussoirs, des coussinets et des vilebrequins.

## Revendications

1. Pièce mécanique de friction pour moteurs à combustion interne revêtue, sur une partie ou sur la totalité de sa surface, d'une couche comprenant au moins un oxyde métallique présentant un défaut stoechiométrique d'oxygène ou un précurseur d'un tel oxyde, caractérisée par le fait que ledit oxyde métallique ou ledit précurseur d'oxyde contient une quantité suffisante pour stabiliser l'oxyde métallique vis-à-vis de l'oxydation, d'au moins un oligoélément choisi parmi Al, Ti, Zr, Co, Cr, Fe, Ni, Mn, Nb et K, différent du métal formant l'oxyde métallique.

2. Pièce mécanique de friction selon la revendication 1, caractérisée par le fait que ladite couche comprenant au moins un oxyde métallique présentant un défaut stoechiométrique d'oxygène ou un précurseur d'un tel oxyde est une couche homogène.

3. Pièce mécanique de friction selon la revendication 1, caractérisée par le fait que ladite couche comprenant au moins un oxyde métallique présentant un défaut stoechiométrique d'oxygène ou un précurseur d'un tel oxyde est une couche composite constituée d'une matrice et de particules dudit oxyde métallique ou dudit précurseur de celui-ci.

4. Pièce mécanique de friction selon la revendication 3, caractérisée par le fait que la matrice est une matrice métallique constituée de fer, de fonte, de nickel, de nickel-phosphore, de chrome ou de cobalt ou d'un alliage de ceux-ci.

5. Pièce mécanique selon la revendication 3, caractérisée par le fait que la matrice est une matrice céramique constituée d'Al₂O₃, de ZrO₂, de Cr₂O₃ ou de TiO₂, ou d'un mélange de ceux-ci.

6. Pièce mécanique selon l'une quelconque des revendications 3 à 5, caractérisée par le fait que la proportion de particules dans ladite couche composite est comprise entre 10 et 80 % en poids.

7. Pièce mécanique selon l'une quelconque des revendications 3 à 6, caractérisée par le fait que les particules d'oxyde métallique présentant un défaut stoechiométrique d'oxygène ou d'un précurseur d'un tel oxyde ont une taille moyenne comprise entre 0,5 et 20 µm.

8. Pièce mécanique de friction selon l'une quelconque des revendications précédentes, caractérisée par le fait que l'oxyde métallique présentant un défaut stoechiométrique d'oxygène est choisi parmi TiₙO₂ₙ₋₁, VₙO₂ₙ₋₁, MoₙO₃ₙ₋₁, MoₙO₃ₙ₋₁, WₙO₃ₙ₋₁, WₙO₃ₙ₋₁ et CrO_{2-y}, où 3 ≤ n ≤ 10 et 0,01 ≤ y ≤ 0,5

9. Pièce mécanique de friction selon l'une quelconque des revendications 1 à 7, caractérisée par le fait que ledit précurseur de l'oxyde métallique présentant un défaut stoechiométrique d'oxygène est choisi parmi les carbure, nitrure et borure de Ti, V, Mo, W et Cr et des mélanges de ceux-ci.

10. Pièce mécanique de friction selon l'une quelconque des revendications précédentes, caractérisée par le fait que ledit ou lesdits oligoéléments sont présents dans ledit oxyde métallique ou ledit précurseur de celui-ci, sous forme métallique à raison de 30 à 3000 ppm en poids, de préférence à raison de 300 à 1000 ppm en poids.

11. Pièce mécanique de friction selon l'une quelconque des revendications 1 à 9, caractérisée par le fait que ledit ou lesdits oligoéléments sont présents dans ledit oxyde métallique ou ledit précurseur de celui-ci, sous forme d'oxyde à raison de 3 à 30 % en atomes (métal et oxygène), de préférence à raison de 10 à 25 % en atomes.

12. Pièce mécanique de friction selon l'une quelconque des revendication précédentes, caractérisée par le fait que l'épaisseur de la couche comprenant au moins un oxyde présentant un défaut stoechiométrique d'oxygène ou un précurseur d'un tel oxyde, est comprise entre 1 µm et et 1000 µm, de préférence entre 10 µm et 200 µm.

13. Pièce mécanique de friction selon l'une quelconque des revendications précédentes, caractérisée par le fait qu'il s'agit d'un arbre à cames, d'un poussoir, d'un piston, d'un segment, d'une chemise, d'un guide de soupape, d'une tige de soupape, d'un coussinet, d'un palier pour vilebrequin, d'une bielle, d'un cylindres de carter, d'un cylindres à fûts intégrés, d'un engrenage de pompe à huile de moteur.

14. Procédé de fabrication d'une pièce mécanique de friction selon l'une quelconque des revendications 1, 2 et 8 à 13, caractérisé par le fait que l'on applique par dépôt chimique en phase vapeur (CVD), par dépôt physique en phase vapeur (PVD) ou par projection thermique - sur une partie ou sur la totalité de la surface d'une pièce de base - une couche d'au moins un oxyde métallique présentant un défaut stoechiométrique d'oxygène et/ou d'un précurseur d'un tel oxyde, stabilisée par la présence d'une quantité suffisante d'au moins un oligoélément choisi parmi Al, Ti, Zr, Co, Cr, Fe, Ni, Mn, Nb et K, différent du métal formant l'oxyde métallique.

15. Procédé de fabrication d'une pièce mécanique de friction selon l'une quelconque des revendications 1, 2 et 8 à 13, caractérisé par le fait que l'on soumet la pièce de base à un traitement thermochimique consistant à faire diffuser à des températures comprises entre 600 °C et 1000 °C et jusqu'à une profondeur comprise entre 5 µm et 30 µm, un agent de vanadation contenant une quantité appropriée dudit ou desdits oligoélément(s), de manière à former sur une partie ou sur la totalité de la surface de la pièce une couche formatrice d'oxyde à défaut stoechiométrique d'oxygène.

16. Procédé de fabrication d'une pièce mécanique de friction selon l'une quelconque des revendications 1, 2 et 8 à 13, caractérisé par le fait que l'on soumet la pièce de base à un traitement thermochimique consistant à faire diffuser à des températures comprises entre 800 °C et 1000 °C et jusqu'à une profondeur comprise entre 5 µm et 500 µm, un agent de boruration contenant une quantité appropriée dudit ou desdits oligoélément(s), de manière à former sur une partie ou sur la totalité de la surface de la pièce une couche formatrice d'oxyde à défaut stoechiométrique d'oxygène.

17. Procédé de fabrication d'une pièce mécanique de friction selon l'une quelconque des revendications 1 et 3 à 13, caractérisé par le fait que l'on applique par projection thermique une dispersion de particules d'au moins un oxyde métallique présentant un défaut stoechiométrique d'oxygène et stabilisé par la présence d'une quantité suffisante d'au moins un oligoélément choisi parmi Al, Ti, Zr, Co, Cr, Fe, Ni, Mn, Nb et K, différent du métal formant l'oxyde métallique, de manière à former sur une partie ou sur la totalité de la surface de la pièce de base un revêtement composite (matrice métallique ou céramique contenant des particules desdits oxydes).

18. Procédé de fabrication d'une pièce mécanique de friction selon l'une quelconque des revendications 1 et 3 à 13, caractérisé par le fait que l'on soumet la pièce de base à un placage électrochimique ou chimique avec une dispersion de particules d'oxyde présentant un défaut stoechiométrique d'oxygène et stabilisé par la présence d'une quantité suffisante d'au moins un oligoélément choisi parmi Al, Ti, Zr, Co, Cr, Fe, Ni, Mn, Nb et K, différent du métal formant l'oxyde métallique, de manière à former sur une partie ou sur la totalité de la surface de la pièce de base un revêtement composite (matrice métallique contenant des particules desdits oxydes).

19. Utilisation d'oligoéléments pour stabiliser des revêtements anti-usure à base d'oxydes métalliques présentant des défauts stoechiométriques d'oxygène, caractérisée par le fait que lesdits oligoéléments sont choisis parmi Al, Ti, Zr, Co, Cr, Fe, Ni, Mn, Nb et K et sont utilisés sous forme métallique à raison de 30 à 3000 ppm en poids ou sous forme d'oxyde à raison de 3 à 30 % en atomes de métal et d'oxygène.

20. Dispositif constitué d'un premier triboélément revêtu, sur une partie ou sur la totalité de sa surface, d'une couche d'au moins un oxyde métallique présentant un défaut stoechiométrique d'oxygène, et d'un deuxième élément revêtu d'un oxyde de Al, Ti, Zr, Co, Cr, Fe, Ni, Mn, Nb et K.
